(19) **Europäisches Patentamt / European Patent Office / Office européen des brevets**

(11) **EP 1 424 405 B1**

(12) **EUROPÄISCHE PATENTSCHRIFT**

(45) Veröffentlichungstag und Bekanntmachung des Hinweises auf die Patenterteilung:
**03.01.2007 Patentblatt 2007/01**

(51) Int Cl.:
*C23C 16/50* (2006.01)   *C30B 25/10* (2006.01)

(21) Anmeldenummer: **04004051.1**

(22) Anmeldetag: **27.05.1998**

(54) **Verfahren und Anlage zur Herstellung beschichteter Werkstücke**

Method and apparatus for fabricating coated substrates

Procédé et appareil pour la fabrication de substrats revêtus

(84) Benannte Vertragsstaaten:
**AT BE CH DE ES FR GB IE IT LI NL SE**

(30) Priorität: **13.06.1997 CH 144597**

(43) Veröffentlichungstag der Anmeldung:
**02.06.2004 Patentblatt 2004/23**

(62) Dokumentnummer(n) der früheren Anmeldung(en) nach Art. 76 EPÜ:
**98920439.1 / 0 988 407**

(73) Patentinhaber: **Oerlikon Trading AG, Trübbach**
**9477 Trübbach (CH)**

(72) Erfinder:
- **Ramm, Jürgen**
  **9475 Sevelen (CH)**
- **von Känel, Hans**
  **8304 Wallisellen (CH)**
- **Rosenblad, Carsten**
  **8049 Zürich (CH)**

(74) Vertreter: **Troesch Scheidegger Werner AG**
**Schwäntenmos 14**
**8126 Zumikon (CH)**

(56) Entgegenhaltungen:
DE-A- 3 614 384     GB-A- 2 219 578
US-A- 4 443 488     US-A- 5 554 222

- SHANFIELD S.R.: "PLASMA-ENHANCED CHEMICAL VAPOR DEPOSITION OF EPITAXIAL SILICON FROM SILANE" EXTENDED ABSTRACTS, Bd. 83-1, 1983, Seiten 230-231, XP002056339 US

- MANTEI T.D ET AL: "LOW TEMPERATURE DEPOSITIONOF MICROCRYSTALLINE SILICON IN A MULTIPOLAR PLASMA" EXTENDED ABSTRACTS, Bd. 85, Nr. 2, 1985, Seiten 396-397, XP002056340 US

- STIEGLER J ET AL: "PLASMA-ASSISTED CVD OF DIAMOND FILMS BY HOLLOW CATHODE ARC DISCHARGE" DIAMOND AND RELATED MATERIALS, Bd. 2, Nr. 2 / 04, 31. März 1993 (1993-03-31), Seiten 413-416, XP000360820

- SOLOMON S J: "Silicon from silane through plasma deposition" FIFTEENTH IEEE PHOTOVOLTAIC SPECIALISTS CONFERENCE - 1981, KISSIMMEE, FL, USA, 12-15 MAY 1981, 12. Mai 1981 (1981-05-12), Seiten 569-571, XP002056341 1981, NEW YORK, NY, USA, IEEE, USA

- KORNER N ET AL: "Hydrogen plasma chemical cleaning of metallic substrates and silicon wafers" 22ND INTERNATIONAL CONFERENCE ON METALLURGICAL COATING AND THIN FILMS, SAN DIEGO, CA, USA, 24-28 APRIL 1995, Bd. 77, Nr. 1-3, 1. April 1995 (1995-04-01), Seiten 731-737, XP002056342 ISSN 0257-8972, SURFACE AND COATINGS TECHNOLOGY, DEC. 1995, ELSEVIER, SWITZERLAND

- SINGH B ET AL: "HOLLOW CATHODE PLASMA ASSISTED CHEMICAL VAPOR DEPOSITION OF DIAMOND" APPLIED PHYSICS LETTERS, Bd. 52, Nr. 20, 16. Mai 1988 (1988-05-16), Seiten 1658-1660, XP000119536

- PANDE K.P ET AL: "LOW TEMPERATURE PLASMA-ENHANCED EPITAXY OF GAAS" JOURNAL OF THE ELECTROCHEMICAL SOCIETY, Bd. 131, Nr. 6, Juni 1984 (1984-06), Seiten 1357-1359, XP002056343 US

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Es geht die vorliegende Erfindung von den Problemen aus, die sich bei der Herstellung dünner Schichten mit CVD- und PECVD-Verfahren ergeben. Die dabei erfindungsgemäss gemachten Erkenntnisse lassen sich z.B. bei der Solarzellen-Herstellung oder der Herstellung modulationsdotierter FET's oder heterobipolarer Transistoren einsetzen.

Dünne Halbleiterfilme bzw. -schichten werden entweder in einkristalliner Form, d.h. epitaktisch, auf ein ebenfalls einkristallines Substrat, wie ein Siliziumsubstrat abgeschieden, oder aber in polykristalliner Form oder amorpher Form auf polykristalline oder amorphe Substrate, z.B. auf Glas. Obwohl im folgenden die Erfindung mit Bezug auf die Herstellung Silizium- und/oder Germanium-beschichteter Substrate beschrieben wird, kann sie, wie erwähnt, auch für die Herstellung anderer und mit anderen Materialien beschichteter Werkstücke eingesetzt werden.

Bekannte Verfahren zur Abscheidung epitaktischer Halbleiterfilme sind:

- Molekularstrahl-Epitaxie, MBE (Molecular Beam Epitaxy)

- Thermo-Chemische Gasphasenabscheidung, CVD (Chemical Vapour Deposition)

- Remote-Plasmaunterstützte CVD-Verfahren mit DC- oder Hf-Entladung, RPECVD (Remote-Plasma-Enhanced CVD)

- Mikrowellen-Plasmaunterstützte chemische Gasphasenabscheidung und ECRCVD (Electron-Cyclotron-Resonance-Plasma-Assisted CVD) Beim CVD-erfahren handelt es sich um einen Sammelbegriff einer grossen Anzahl von thermischen Abscheidungsmethoden, die sich entweder durch den Aufbau der zugeordneten Apparaturen unterscheiden, oder durch deren Betriebsart. So kann z.B. ein CVD-Verfahren bei Normal-Atmosphärendruck durchgeführt werden, oder aber bei viel kleineren Drücken bis hinunter ins Gebiet des Ultra-Hochvakuums. Es kann hierzu auf (1) verwiesen werden, sowie auf (2).

In der kommerziellen Produktion von epitaktischen Si-Schichten ist ausschliesslich CVD gebräuchlich. Die verwendeten Reaktivgase sind dabei siliziumhaltige Gase, z.B. Chlorsilane, $SiCl_4$, $Si_3HCl$ und $SiH_2Cl_2$ sowie Silane, z.B. $SiH_4$ oder $Si_2H_6$. Charakteristisch für die Standard-CVD-Verfahren sind die hohen Abscheide-Temperaturen in der Grössenordnung von 1000°C und mehr, sowie Drücke von typischerweise 20 mbar bis 1000 mbar, d.h. bis Normal-Atmosphärendruck.

Je nach Prozessbedingungen können damit Beschichtungsraten von mehreren $\mu$m pro Minute erzielt werden, entsprechend mehreren 100 Å/sec, wozu wiederum auf (1) verwiesen sei.

Niederdruck-chemische Gasphasenabscheidung (LPCVD, Low Pressure Chemical Vapour Deposition, gleichbedeutend mit LPVPE, Low-Pressure Vapour Phase Epitaxy) findet dagegen bei Drücken unter 1 mbar statt und erlaubt tiefere Prozesstemperaturen bis auf typischerweise 700°C. Diesbezüglich sei nebst auf (1) auch auf (3) und (6) verwiesen.

Bezüglich LPCVD und unter Verweis auf (6) wird bei einer Abscheidetemperatur von 650°C eine Wachstumsrate (growth rate) von

$$GR = 50 \text{ Å/min}$$

angegeben. Dies bei einem Reaktivgasfluss für Silan von

$$F = 14 \text{ sccm.}$$

Daraus ergibt sich eine für die Gasausbeute relevante Kennzahl, nämlich die Wachstumsrate pro Reaktivgasfluss-Einheit, $GR_F$ zu

$$GR_F = 3,6 \text{ Å/(sccm} \cdot \text{min)}$$

Auf 5"-Wafern, entsprechend einer Fläche

$$A_5 = 123 \ cm^2,$$

umgerechnet von der aktuellen Fläche $A_2$ für 2"-Wafer ergibt sich eine Abscheidemenge (growth amount) GA zu

$$GA = 5,2 \cdot 10^{16} \ Si\text{-}Atome/sec.$$

Wiederum bezogen auf eine Reaktivgasfluss-Einheit ergibt sich die Kennzahl "Abscheidemenge pro Reaktivgasfluss-Einheit", im weiteren "Gasausnützungszahl" genannt, $GA_F$ zu

$$GA_F = 8,4 \cdot 10^{-3},$$

entsprechend 8,4 0/00.

Bei 650°C entsteht eine epitaktische Schicht.

Wird die Abscheidetemperatur auf 600°C reduziert, so entsteht eine polykristalline Schicht. Dies mit:

$$GR = 3 \ Å/min$$

$$F = 28 \ sccm \ Silan$$

$$GR_F = 0,11 \ Å/(sccm/min)$$

$$GA = 3,1 \cdot 10^{15} \ Si\text{-}Atome/sec \ auf \ A_5$$

$$GA_F = 2,5 \cdot 10^{-4}, \ entsprechend \ 0,25 \ 0/00.$$

Grundsätzlich sind folgende Kriterien für ein defektfreies epitaktisches Schichtwachstum erforderlich:

- Bei Transmissionselektronen-Mikroskopie an Querschnittspräparaten wird der Nachweis der Epitaxie durch Elektronendiffraktion und Hochauflösung erstellt.

- In dabei typischerweise durchstrahlbaren Bereich von 10 - 15 $\mu$m längs der Grenzfläche zum Substrat, dürfen keine Defekte sichtbar sein. Typische Vergrösserungen bei der Defektanalyse sind 110'000 bis 220'000.

Eine weitere Entwicklung ist die Ultrahochvakuum-chemische Gasphasenabscheidung (UHV-CVD) mit Arbeitsdrücken im Bereich von $10^{-4}$ bis $10^{-2}$ mbar, typischerweise im Bereich von $10^{-3}$ mbar, wozu verwiesen sei auf (4) sowie auf (5), (7). Sie lässt sehr niedrige Werkstücktemperaturen zu, wobei allerdings die Wachstums- bzw. Beschichtungsraten extrem klein sind, so z.B. ca. 3 Å/min für reines Silizium bei 550°C gemäss (5).

Der Grund für die kleinen Wachtumsraten liegt darin, dass die Absorptions- und Zerfallsrate der reaktiven Moleküle, so z.B. von $SiH_4$, mit zunehmender Wasserstoffbelegung der WerkstückOberfläche abnimmt. Das Schichtwachstum wird also durch die Desorptionrate von $H_2$ limitiert, die aber exponentiell mit der Temperatur zunimmt. Hierzu sei auf (8) verwiesen. Wegen der kleineren Bindungsenergie der Ge-H-Bindung im Vergleich zur Si-H-Bindung ist die Wasserstoffdesorption von einer Si-Ge-Legierungsoberfläche grösser, so dass bei gleicher Substrattemperatur eine höhere Wachstumsrate als bei reinem Si resultiert, z.B. bei einem Gehalt von 10% Ge um einen Faktor 25 bei 550°C (5).

Eine weitere Möglichkeit, bei niedrigen Substrattemperaturen hohe Abscheideraten mit Epitaxie-Qualität zu erzielen, besteht darin, (9), die reaktiven Gase mit Hilfe eines μ-Wellen-Plasmas zu zersetzen (ECRCVD).

Durch den Einsatz von Plasmaquellen, die auf dem Prinzip der Elektronen-Zyklotron-Resonanz beruhen, soll der Einfall hochenergetischer Ionen auf das Substrat vermieden werden.

Solche Quellen arbeiten in der Regel im Druckbereich von $10^{-3}$ bis $10^{-4}$ mbar, was aber zu grösseren freien Weglängen führt, als im Fall von kapazitiv eingekoppelten Hochfrequenz-Hf-Plasmen. Dies kann wiederum zu unerwünschtem Ionenbeschuss des Substrates führen und damit zur Erzeugung von Defekten, wie sich aus (10) ergibt. Die Energie der auf das Substrat auftreffenden Ionen kann aber durch eine externe Kontrolle des Substratpotentials begrenzt werden, wodurch sich Ionenschäden weitgehend vermeiden lassen. Auch mit ECRCVD-Methode betragen die Wachstumsraten für reines Silizium in der Regel nur einige 10 Å/min, bei tiefen Abscheidetemperaturen ≤ 600°C.

Zusammengefasst ergibt sich folgendes:

Schichten, die mit einer Qualität abgelegt werden, die sich auch für das Ablegen von epitaktischen Schichten eignet, können, bei Abscheidetemperaturen 5 600°C, bis heute:

•  durch UHV-CVD mit Wachstumsraten GR von ca. 3 Å/min oder

•  durch ECRCVD mit einer um ca. 1 Grössenordnung (30 Å/min) höheren Wachstumsrate GR

abgelegt werden.

PECVD-Verfahren, deren Plasma durch DC-Entladungen erzeugt werden, konnten für die Fertigung von Schichten mit Epitaxie-Qualität - d.h. entsprechend geringer Fehlerdichte (siehe oben) - weder für den Aufbau von epitaktischen noch für den Aufbau amorpher oder polykristalliner Schichten eingesetzt werden, mindestens nicht mit einer für industrielle Fertigung sicherzustellenden Wachstumsrate GR, Zuverlässigkeit und Effektivität bzw. Wirkungsgrad.

Über die Verwendung von kapazitiv eingekoppelten Hochfrequenzfeldern zur Erzeugung von Hf-Plasmen für PECVD-Verfahren wurde anderseits schon sehr früh berichtet, wozu verwiesen sei auf (11). Die Schwierigkeit bei diesem Vorgehen liegt darin, dass in solchen Hf-Plasmen nicht nur die reaktiven Gase zersetzt werden. Gleichzeitig ist die Substratoberfläche einem intensiven Beschuss hochenergetischer Ionen ausgesetzt, wie dies spezifisch auch bei reaktivem Zerstäuben oder Hochfrequenzätzen ausgenützt wird. Dies begünstigt einerseits die Wasserstoff-Desorption, führt aber gleichzeitig zu Defekten in den wachsenden Schichten. Eine davon abgewandelte Methode, die RPCVD, Remote Plasma Chemical Vapour Deposition, berücksichtigt dies dadurch, dass die zu beschichtenden Substrate nicht direkt dem Hf-Plasma ausgesetzt werden, was zu besseren Resultaten führt (12). Allerdings sind die erzielten Wachstumsraten gering, nämlich meist Bruchteile von nm pro Minute bis höchstens einige nm pro Minute gemäss (13).

Einschub 2260

Aus STIEGLER J ET AL:"PLASMA-ASSISTED CVD OF DIAMOND FILMS BY HOLLOW CATHODE ARC DISCHARE" DIAMOND AND RELATED MATERIALS, Bd. 2, Nr.2/04, 31. März 1993(1993-03-31), Seiten 413-416, XP000360820 (D2) ist es bekannt polykristalline Diamantschichten mittels hohlkathodenentladungsunterstütztem CVD abzulegen. Es sei, so wird ausgeführt, vorteilhaft, dass keine Hilfsheizung notwendig ist, weil das Substrat durch Energieübertragung von der Heizkathode und dem Plasma beheizt wird. Zwischen Substrat und Hohlkathode ist der Abstand 20mm bis 50mm. Die Entladespannung betragt 80V bis 200V.

In SOLOMON S J:"Silicon from silane through plasma deposition" FIFTEENTH IEEE PHOTOVOLTAIC SPECIALISTS CONFERENCE - 1981, KISSIMMEE, FL, USA, 12-15 MAY 1981 (1981-05-12), Seiten 569-571, XP00205341 (D3) wird ein Plasma eingesetzt, dass eine tiefe Jonendichte und eine tiefe Jonenenergie hat um hochreine Siliziumschichten mittels PECVD abzulegen.

Aus SINGH B ET AL:"HOLLOW CATHODE PLASMA ASSISTED CHEMICAL VAPOR DEPOSITION OF DIAMOND" APPLIED PHYSICS LETTERS, Bd. 52, Nr. 20, 16. Mai 1988 (1988-05-16), Seiten 1658-1660, XP000119536 (D4) ist es bekannt polykristalline Diamantfilme mittels PECVD abzulegen. Die Entladungsspannung von 75 bis 115V liegt an einer Strecke von 5 bis 30mm. Auch hier sei eine Heizung für das Substrat nicht nötig, denn letzteres werde durch Plasmabeschuss geheizt.

Aus der US-A-4 443 488 (LITTLE ROGER G ET AL) 17.April 1984 (1984-04-17)(D5) ist es bekannt dünne Halbleiterfilme auf kostengünstige, amorphe Substrate abzulegen. Bei ca. $10^{-6}$mbar werden Ionen mittels Elektronenrückhaltegittern und Ionbeschleunigungsgittern auf ein Substrat getrieben. Das Substrat wird bevorzugt direkt durch den Ionenaufprall beheizt. Es ist einleitend erwähnt es sei bekannt gewesen Siliziumfilme epitaxial aufzuwachsen.

Aus PANDE K.P ET AL:"LOW TEMPERATURE PLASMA-ENHANCED EPITAXY OF GAAS" JOURNAL OF THE ELECTROCHEMICAL SOCIETY, Bd. 131, Nr. 6, Juni 1984 (1984-06), Seiten 1357-1359, XP002056343 (D6) ist es bekannt GaAs Epitaxialschichten mittels PECVD abzulegen. Das dem Substrat abgewandte Plasma wird mit einer Entladespannung von 300 bis 350V an einer Strecke von 2 bis 3 Inch erstellt, bei einem Druck von ca. 0,6 bis 1mbar.

Aufgabe der vorliegenden Erfindung ist es, ein in der industriellen Fertigung einsetzbares Verfahren anzugeben, das erlaubt, Schichten mit Epitaxie-Qualität aufzuwachsen mit wesentlich höheren Wachstumsraten, als bis anhin bekannt.

Dies wird durch Verfahren nach Anspruch 1 erreicht. Bevorzugte Ausführungsformen des Verfahrens sind in den Ansprüchen 2 bis 19 spezifiziert. Das erfindungsgemässe Verfahren eignet sich insbesondere für die Herstellung von Substraten mit epitaktischer, amorpher oder polykristalliner HalbleiterSchicht, dabei insbesondere von Si-, Ge- oder Si/Ge-LegierungsSchichten sowie von Ga- oder Ga-Verbindungs-Schichten.

Dabei können insbesondere auch dotierte Halbleiterschichten abgelegt werden. Silizium und/oder Germanium enthaltende Schichten, dotiert vorzugsweise mit mindestens einem Element aus den Gruppen III oder V des Periodensystems bzw. Gallium enthaltende Schichten mit mindestens einem Element der Gruppen II, III, IV oder VI des Periodensystems, z.B. mit Mg oder Si.

Aus den eingangs abgehandelten Beschichtungstechniken zur Erzeugung epitaktischer Schichten kann zusammenfassend folgendes ausgeführt werden:

- Die CVD-Verfahren, insbesondere die UHV-CVD-Verfahren führen zu ausgezeichneten Schichtqualitäten, selbst bei Substrattemperaturen unterhalb von 500°C. Sie bieten sich deshalb an, auch epitaktische Schichten herzustellen, wo an die Schichtqualität extrem hohe Anforderungen gestellt werden. Die Wachstumsrate beispielsweise für Si ist aber bei diesen Verfahren extrem tief, wie erwähnt in der Grössenordnung von 3 Å/min bei 550°C.

- Mikrowellen-Plasma-unterstützte Verfahren, ECRCVD, haben den Vorteil, dass die Zersetzung der reaktiven Moleküle ohne hohe thermische Energie stattfinden kann. Der Ionenbeschuss des Substrates führt zu erhöhter Wasserstoffdesorption. Beide Effekte könnten zu einer beträchtlichen Zunahme der Wachstumsrate führen. Bei tiefen Temperaturen werden aber inakzeptabel hohe Defekt-Dichten beobachtet, induziert durch Ionenbeschuss. Eine Kontrolle über die Substrat-Bias-Spannung erhöht zwar die Schichtqualität, ändert aber nichts an den vergleichsweise kleinen Raten.

Damit scheint ein inhärenter Widerspruch zu bestehen:

Ionenbeschuss des Substrates führt einerseits zu erhöhter Wachstumsrate aufgrund erhöhter Wasserstoffdesorption, führt aber gleichzeitig zur Erhöhung der Defekt-Dichte.

Für unter Atmosphärendruck betriebene, thermische CVD-Verfahren ergibt sich laut (2) folgendes Bild:

- Si-Wachstumsrate GR: $2 \times 10^{-3}$ nm/min
  (bei 600°C, $3 \cdot 10^{-2}$ nm/min gemessen und auf 550°C umgerechnet)

- Gasfluss, $SiCl_2H_2$, F: 100 sccm.

Daraus ergibt sich eine Wachstumsrate GR pro $SiCl_2H_2$-Fluss-Einheit, $GR_F \approx 2 \times 10^{-4}$ Å/(sccm.min).

Ein Gasfluss F von 100 sccm $SiCl_2H_2$ entspricht $4,4 \times 10^{19}$ Molekülen/sec.

Die Wachstumsrate GR von $2 \times 10^{-3}$ nm/min entspricht einer Wachstumsrate von $2 \times 10^{-4}$ Silizium-Monolagen pro Sekunde auf einem 5"-Wafer, entsprechend einer Fläche $A_5$ von 123 cm$^2$. Damit ergibt sich auf der Gesamtfläche pro Sekunde eine abgelegte Menge von

$$GA = 1,7 \times 10^{13} \text{ Siliziumatome/sec.}$$

Durch Inbeziehungsetzen der pro Sekunde abgelegten Siliziummenge und der pro Sekunde eingelassenen Reaktivgasmenge ergibt sich die Gasausnützungsziffer $GA_F$ zu

$$GA_F = 3,9 \times 10^{-7}.$$

Dies entspricht einer Ausnützung von ungefähr 0,0004 0/00.

Wir halten fest, dass sich bei atmosphärischem CVD ergibt:

$$GR_F \approx 2 \times 10^{-4} \ \text{Å}/(\text{sccm.min})$$

$$GA_F \approx 0,0004 \ 0/00.$$

Aus (5), kombiniert mit (4) und (7), ergibt sich die Abschätzung für UHV-CVD zu

$$GR_F \approx 0,1 \ \text{Å}/(\text{sccm.min})$$

und

$$GA_F \approx 0,0035 \ \text{entsprechend ca. } 35 \ 0/00.$$

Dies zu den bis anhin industriell eingesetzten Verfahren für die Herstellung von Schichten in Epitaxie-Qualität.

Aus der DE-OS 36 14 384 ist nun weiter ein PECVD-Verfahren bekannt, bei welchem DC-Glimmentladung in Form einer Niederspannungs-Entladung eingesetzt wird. Damit sollen Schichten mit besonders guten mechanischen Eigenschaften schnell, d.h. mit hoher Wachstumsrate, abgelegt werden.

Eine Kathodenkammer mit Heisskathode kommuniziert mit einem Vakuumrezipienten über eine Blende. Der Blende gegenüberliegend ist eine Anode vorgesehen. Parallel zu der zwischen Blende und Anode gebildeten Entladungsachse ist eine Einlassanordnung für ein Reaktivgas vorgesehen, dieser Anordnung, bezüglich der Entladungsachse gegenüberliegend, sind die Werkstücke angeordnet. Mit Bezug auf Anodenpotential, werden Entladungsspannungen $U_{AK}$ unterhalb 150 V angelegt, und die Entladung wird mit einer Stromstärke $I_{AK}$ von wenigstens 30 A betrieben. Für die Beschichtung werden die Werkstücke auf negative Potentiale zwischen 48 und 610 V gebracht.

Die darin gezeigten Versuche ergeben folgendes Bild:

| Beispiel | GR[Å/min] | $GR_F$ [Å/ sccm.min)] |
|---|---|---|
| 1 | $10^3$ | 2,5 |
| 2 | 380 | 1,2 |
| 3 | $2 \times 10^3$ | 2,5 |
| 4 (Si) | 166 | 0,7 |
| 5 | 466 | 1,2 |
| 6 | 750 | 0,7 |
| 7 | 250 | 0,5 |
| 8 | 500 | 0,75 |
| 9 | 316 | 0,38 |
| 10 | 344 | 0,18 |
| 11 | 62 | 0,18 |
| 12 | 58 | 0,14 |

Die vorliegende Erfindung geht nun davon aus, dass Werkstückbeschichtungen mit einer Schichtqualität vorgenommen werden können, welche Qualität den an Epitaxieschichten zu stellenden Anforderungen genügt, indem hierzu, entgegen den bisher gehegten Erwartungen, ein nicht-Mikrowellen-Plasma-PECVD-Verfahren eingesetzt wird - d.h. ein PECVD-Verfahren mit DC-Entladung - und im speziellen ein PECVD-Verfahren, wie es, von seinem Prinzip her, aus der DE-OS 36 14 348 bekannt ist. Wie gezeigt werden wird, ist es dabei möglich, in Epitaxie-Qualität

a) Wachstumsraten GR von mindestens 150 Å/min, gar von mindestens 600 Å/min

b) GR$_F$ von mindestens 7,5 Å/(sccm.min), oder gar 40 Å/(sccm.min), vorzugsweise gar 75 Å/(sccm.min) zu erzielen, und weiter

c) Gasausnützungsziffern GA$_F$ zu erzielen mindestens im Bereich von 5%.

Es wird erkannt, dass am erfindungsgemäss eingesetzten DC-PECVD-Verfahren die Plasmaentladung zu tiefstenergetischen Ionen führt, ebenso zu tiefstenergetischen Elektronen, dass aber die Ladungsträgerdichte, insbesondere die Elektronendichte an der ausgenützten Entladung sehr gross ist.

Die Erfindung wird anschliessend anhand von Figuren beispielsweise erläutert. Es zeigen:

Fig. 1:     schematisch eine erste bevorzugte Ausführungsform einer Anlage zur Durchführung der erfindungsgemässen Verfahren,

Fig. 2:     schematisch eine zweite bevorzugte Ausführungsform einer Anlage gemäss Fig. 1 mit mehreren Betriebsvarianten,

Fig. 3:     bei Betrieb einer Anlage gemäss Fig. 2 für eine Siliziumbeschichtung, die Abhängigkeit der Wachstumsrate von der Wafer-Temperatur,

Fig. 4:     in Funktion des Entladungsstromes, die Zunahme der Wachstumsrate bezogen auf den Reaktivgasfluss, GR$_F$,

Fig. 5:     in Funktion des Reaktivgasflusses, die Wachstumsrate bei unterschiedlichen Plasmadichten im Bereich der Werkstücke,

Fig. 6:     in Funktion der Germanium-Konzentration an der abgeschiedenen Schicht, die Wachstumsrate und

Fig. 7:     Im Feld Wachstumsrate/Gasausnützungsziffer die Resultate gemäss Stand der Technik und gemäss Erfindung.

Vorab, eine Anlage gemäss z.B. der DE-OS 36 14 384 kann durchaus für die Durchführung der erfindungsgemässen Verfahren eingesetzt werden, sofern sie so betrieben wird, dass die erfindungsgemässen Bedingungen eingehalten werden.

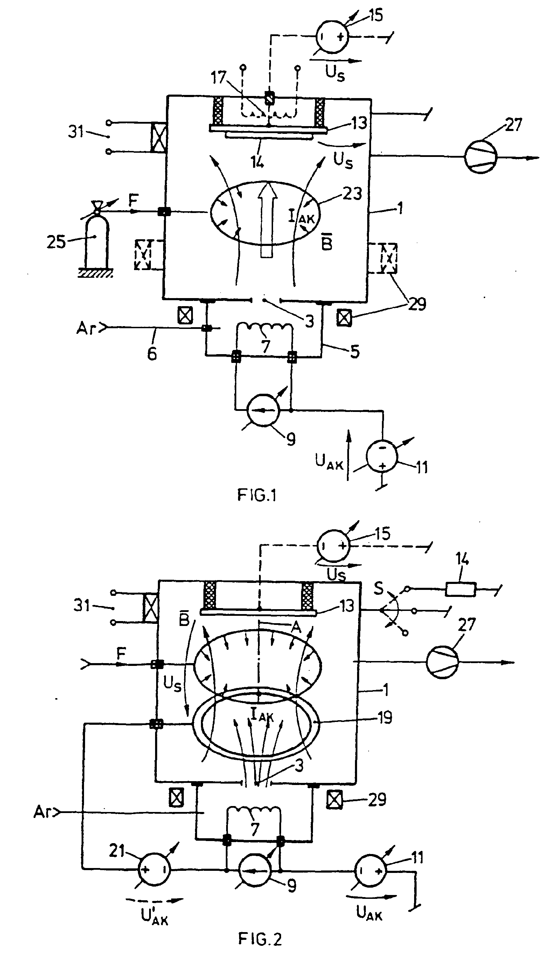

Gemäss Fig. 1 weist eine heute bevorzugte erste Anlage zur Durchführung des erfindungsgemässen Verfahrens einen Vakuumrezipienten 1 auf, an welchen, über eine Blende 3, eine Kathodenkammer 5 angeflanscht ist. In bekannter Art und Weise kann die Kathodenkammer 5 auf das elektrische Potential des Rezipienten 1 gelegt sein, oder die Kathodenkammer 5 kann bezüglich des Rezipienten 1 isoliert und auf davon abweichendes Potential gelegt sein (nicht dargestellt).

In der Kathodenkammer 5 ist eine Heisskathode 7, ein Filament, vorgesehen, vorzugsweise direkt beheizt mittels eines Heizstromgenerators 9.

In der Blenden-Achse A, der Blende 3 im Rezipienten 1 gegenüberliegend, ist ein isoliert montierter Werkstückträger 13 vorgesehen. Im Bereich des Werkstückträgers 13 kann eine Werkstückheizung 17 vorgesehen sein. Der Rezipient 1 wird mit einer Vakuumpumpe 27, vorzugsweise einer Turbovakuumpumpe, dabei vorzugsweise einer Turbomolekularpumpe evakuiert. Sensoren, wie z.B. ein Plasmamonitor etc., können, zu Beobachtungs- und ggf. Steuerzwecken, an einem Anschluss 31 vorgesehen werden.

Konzentrisch zur Achse A der Entladung mit dem Entladungs-Strom I$_{AK}$ ist ein Gaseindüsring 23 vorgesehen als Reaktivgaseindüsanordnung, verbunden mit einer Gastankanordnung 25 für Reaktivgas, welches, mit steuerbarem Fluss F (sccm), in den Rezipienten eingelassen wird.

In die Kathodenkammer 5 mündet ein Anschluss 6 zu einem Arbeitsgastank, beispielsweise mit Ar. Mittels einer Elektro- und/oder Permanent-Magnetanordnung 29 wird im wesentlich konzentrisch zur Achse A im Rezipienten, ein Magnetfeld B erzeugt, insbesondere auch wirksam im Bereich der Blende 3. Das Feld kann dabei vorzugsweise aus der Konzentrizität verschoben werden.

Die Anlage in ihrer Ausführungsform gemäss Fig. 1 wird wie folgt betrieben:

-     Die Rezipientenwand entsprechend 1 wird als Anode der Entladung eingesetzt und ist hierzu auf ein Bezugspotential, wie dargestellt vorzugsweise auf Masse, geschaltet. Entsprechend ist mittels eines vorzugsweise einstellbaren DC-Generators 11 die Kathode 7 auf (negatives) Potential gelegt. Über dem Generator 11 liegt die Entladespannung U$_{AK}$, der Entladestrom I$_{AK}$ fliesst zwischen Kathode 7 und Rezipienten 1.

- In einer zweiten Betriebsvariante der in Fig. 1 dargestellten Anlage wird der Werkstückträger 13 mittels eines DC-Bias-Generators 15 auf die Spannung $U_S$ gelegt.

In Fig. 2 ist eine weitere bevorzugte, Anlage zur Durchführung des erfindungsgemässen Verfahrens dargestellt. Es sind für gleiche Teile dieselben Bezugszeichen wie in Fig. 1 verwendet. Die Anlage nach Fig. 2 unterscheidet sich wie folgt von der in Fig. 1 dargestellten und beschriebenen:

Es ist eine ringförmige Hilfsanode 19 vorgesehen, welche konzentrisch zur Entladungsachse A angeordnet ist.

Folgende Betriebsarten sind hier möglich:

- Wie mit dem Variationsschalter S schematisch dargestellt, wird die Rezipientenwandung des Rezipienten 1, wie bereits in Fig. 1, auf Bezugs- vorzugsweise Massepotential gelegt oder, über ein Impedanzelement 14, vorzugsweise ein Widerstandselement, an ein Potential, vorzugsweise das Bezugspotential, gefesselt oder aber potential-schwebend betrieben. Die Hilfsanode 19 wird dann, wenn der Rezipient 1 auf Bezugspotential gelegt ist entweder auf das Potential des Rezipienten gelegt oder mittels eines vorzugsweise einstellbaren DC-Generators 21 an Spannung gelegt.

- Wenn der Rezipient 1 über Impedanzelement 14 an ein Bezugspotential gefesselt wird, dann wird die Hilfsanode mittels des DC-Generators 21 betrieben, es erscheint die Entladespannung $U_{AK}$ wie gestrichelt dargestellt zwischen Kathode 7 und Hilfsanode 19. Dies ist auch dann der Fall, wenn die Rezipientenwandung 1 potential-schwebend betrieben wird.

Heute wird der Betrieb der Anlage nach Fig. 2 mit auf Masse gelegter Rezipientenwand und Hilfselektrode 19 sowie potential-kontrolliert betriebenem Werkstückträger 13 bevorzugt. In allen Anlagen-Varianten sind folgende Einstellungen wesentlich:

• Totaldruck $P_T$ im Rezipienten:

$$10^{-4} \text{ mbar} \leq P_T \leq 10^{-1} \text{ mbar}$$

vorzugsweise

$$10^{-3} \text{ mbar} \leq P_T \leq 10^{-2} \text{ mbar}$$

typischerweise im Bereich von $5 \cdot 10^{-3}$ mbar. Dieser Druck wird vornehmlich sichergestellt durch den Partialdruck des Arbeitsgases, vorzugsweise Argon. Die Vakuumpumpe 27 ist deshalb, wie erwähnt, vorzugsweise als Turbovakuumpumpe ausgebildet, insbesondere als Turbomolekularpumpe.

• Arbeitsgasdruck $P_A$:

Dieser wird wie folgt gewählt:

$$10^{-4} \text{ mbar} \leq P_A \leq 10^{-1} \text{ mbar}$$

vorzugsweise zu

$$10^{-3} \text{ mbar} \leq P_A \leq 10^{-2} \text{ mbar}$$

•Reaktivgaspartialdruck $P_R$:

Dieser wird vorzugsweise wie folgt gewählt:

$$10^{-5} \text{ mbar} \leq P_R \leq 10^{-1} \text{ mbar}$$

vorzugsweise zu

$$10^{-4} \text{ mbar} \leq P_R \leq 10^{-2} \text{ mbar.}$$

Insbesondere für Silizium- und/oder Germanium-haltige Gase werden Partialdrücke zwischen $10^{-4}$ mbar und 25 $10^{-3}$ mbar angeraten. Zur Unterstützung der Planarität (Oberflächenrauhigkeit), vor allem für Mehrfachschicht-Abscheidungen und Schichten mit Dotierung wird weiter angeraten, zusätzlich einen Wasserstoff-Partialdruck in der Grössenordnung von $10^{-4}$ bis $10^{-2}$ mbar, vorzugsweise von ca. $10^{-3}$ mbar vorzusehen.

• Gasströme:

Argon: weitestgehend abhängig von Rezipienten- und Kathodenkammer-Volumen, zur Einstellung des erforderlichen Partialdruckes $P_A$ bzw. $P_T$.
Reaktivgasfluss: 1 bis 100 sccm, insbesondere für Silizium- und/oder Germanium-haltige Gase:

$H_2$: 1 bis 100 sccm.

• Entladespannung $U_{AK}$:

Die Entladespannung, sei dies zwischen Kathode 7 und Rezipienten 1 gemäss Fig. 1 oder zwischen Kathode 7, Rezipienten 1 und Hilfsanode 19 bzw. zwischen Kathode 7 und Hilfsanode 19, wird wie folgt eingestellt:

$$10 \text{ V} \leq U_{AK} \leq 80 \text{ V,}$$

vorzugsweise

$$20 \text{ V} \leq U_{AK} \leq 35 \text{ V.}$$

• Entladeströme, $I_{AK}$:

Diese werden wie folgt gewählt:

$$5 \text{ A} \leq I_{AK} \leq 400 \text{ A,}$$

vorzugsweise

$$20 \text{ A} \leq I_{AK} \leq 100 \text{ A.}$$

• <u>Werkstückspannung $U_S$:</u>

In jedem Fall wird diese Spannung unterhalb der Sputterschwelle der Entladung gewählt. Sie wird in allen Fällen wie folgt eingestellt:

$$-25 \text{ V} \leq U_S \leq +25 \text{ V,}$$

vorzugsweise für Ga-Verbindungen, vorzugsweise für Si, Ge und deren Verbindungen

$$-20 \text{ V} \leq U_S \leq +20 \text{ V,}$$

vorzugsweise negativ, und dabei vorzugsweise zu

$$-15 \text{ V} \leq U_S \leq -3 \text{ V.}$$

• <u>Stromdichte am Ort der zu beschichtenden Werkstückoberfläche:</u>

Diese wird vorab mittels einer Sonde am Ort, wo nachmals die zu beschichtende Oberfläche positioniert wird, gemessen. Sie wird eingestellt bezogen auf die Sondenoberfläche zu mindestens 0,05 A/cm$^2$, vorzugsweise zu mindestens 0,1 A/cm$^2$ bis maximal Entladungsstrom/Substratfläche.

Diese Stromdichte wird wie folgt gemessen und eingestellt:

Eine oder mehrere Sonden werden am Ort der nachmals zu beschichtenden Fläche positioniert und bezüglich Masse bzw. Anodenpotential auf variable positive Spannung gelegt. Diese wird solange erhöht, bis der gemessene Strom nicht mehr weiter ansteigt. Der gemessene Stromwert ergibt, bezogen auf die Sondenfläche, die gesamte Stromdichte. Diese wird nun durch Einstellung der Entladung auf den geforderten Wert gestellt. Die Einstellung der erwähnten Stromdichtewerte ist mit den bevorzugt eingestellten Entladeströmen $I_{AK}$ zwischen 5 und 400 A, bzw. und bevorzugt zwischen 20 und 100 A ohne weiteres möglich.

Der hohe Fluss niederenergetischer Ionen und Elektronen, die auf das Werkstück auftreten, ist ein charakteristisches Merkmal des erfindungsgemässen Verfahrens, welches mithin als LEPECVD abgekürzt wird für "Low Energy Plasma Enhanced CVD".

Silizium- und/oder Germaniumschichten können während der Beschichtung durch Zugabe eines Dotierungsgases mit einem Element aus der Gruppe III oder V des periodischen Systems, wie mit Phosphin, Diboran, Arsin etc. zu n- oder p-leitenden Schichten dotiert werden. Somit sind p/n-Halbleiterübergänge in situ herstellbar, z.B. besonders wirtschaftlich für die Solarzellenherstellung.

Werden Galliumschichten oder Galliumverbindungs-Schichten abgelegt, so können diese durch Verwendung eines Dotierungsgases mit einem Element aus den Gruppen II oder III oder IV oder VI des Periodensystems dotiert werden, z.B. mit Mg oder Si.

Mit Hilfe der Anode 19 und/oder des Magnetfeldes B kann die Niederspannungsentladung komprimiert und/oder vom Werkstückträger 13 abgelenkt werden. Damit kann die Plasmadichte am Werkstückträger erhöht (Rate) und/oder über einen grossen Bereich variiert (Einstellung der Verteilung) oder auch gesteuert gewobbelt bzw. abgelenkt werden. Mit Hilfe der Heizung 17 können die Werkstücke bzw. Substrate unabhängig vom Ionen- und/oder Elektronenanfall bis auf ca. 800°C aufgeheizt werden. Die Magnetanordnung 29 erzeugt mittels Permanent- und/oder Elektromagneten das Feld B, vorzugsweise mit einer Flussdichte von einigen 10 bis einigen 100 Gauss im Entladungsraum.

Aufgrund der unüblich tiefen Entladespannungen, wie erwähnt bevorzugt im Bereich von 20 bis 35 V, ergibt sich ein Plasmapotential der Entladung entsprechend (15) nahe am Anodenpotential. Das Werkstück- bzw. Substratpotential kann potentialmässig leicht so verstellt werden, dass die Ionenenergien unterhalb 15 eV liegen, womit sich Ionenschäden während des Schichtwachstums am Werkstück vollständig vermeiden lassen.

Wie erwähnt, wurde, ist eine möglichst hohe Plasmadichte am Werkstück anzustreben. Vorliegendenfalls wird die Plasmadichte durch die Stromdichte an der Werkstückoberfläche gegeben. Sie wird wie vorgängig angegeben mittels Sonden in einem Kalibrier-Arbeitsgang gemessen und eingestellt.

Die Anlagen, wie sie schematisch in den Fig. 1 und 2 dargestellt sind, sind wohl heute bevorzugte Ausführungsformen, wobei die erfindungsgemässen Verfahren sich durchaus auch an Anlagen realisieren lassen, die beispielsweise in der DE-OS 36 14 384 dargestellt sind, wenn sie entsprechend bestückt und geführt werden. Wesentlich erscheint bis heute der potentialkontrollierte Betrieb des Werkstückes.

Mittels einer Anlage, wie sie in Fig. 2 schematisch dargestellt ist, wurden 3"-Silizium-Einkristallsubstrate mit Silizium bzw. einer Silizium/Germanium-Legierung epitaktisch beschichtet. Das Volumen des Rezipienten 1 betrug 60 1.

Die Anlage wurde wie folgt betrieben:

Hilfsanode 19 auf Potential des Rezipienten 1; Werkstückträger 13 auf kontrolliertes Biaspotential. Rezipient als Anode auf Masse.

Folgende Arbeitspunkteinstellungen wurden vorgenommen:

• Werkstücktemperaturen $T_S$

Plasmainduziert ergeben sich Werkstücktemperaturen von nur wenigen 100°C, so z.B. von ca. 150°C.

Dies ist ausserordentlich vorteilhaft zum Beschichten thermisch kritischer Substrate, wie z.B. organischer Substrate.

Höhere, erwünschte Temperaturen werden durch separates Heizen erreicht. Für die Herstellung von Si- und/oder Ge-Schichten und Schichten mit Ge-Si-Verbindungen werden Werkstücktemperaturen $T_S$

$$300°C \leq T_S \leq 600°C$$

angeraten, für Ga-Schichten oder Ga-Verbindungsschichten:

$$300°C \leq T_S \leq 800°C.$$

Weil das Verfahren "kalt" ist, ist man höchst flexibel in der Temperatur-Wahl, je nach Schichtmaterial und Substratmaterial.

|  | Fluss [sccm] | Partialdruck [mbar] |
|---|---|---|
| Ar | 50 | $6,8 \times 10^{-3}$ |
| $H_2$ | 5 | $7 \times 10^{-4}$ |
| $SiH_4$ | 10 | $10^{-3}$ |

Entladestrom $I_{AK}$: 70 A.
Entladespannungen $U_{AK}$: 25 V.
Substrat-Temperatur: 550°C (mit Heizung geheizt)

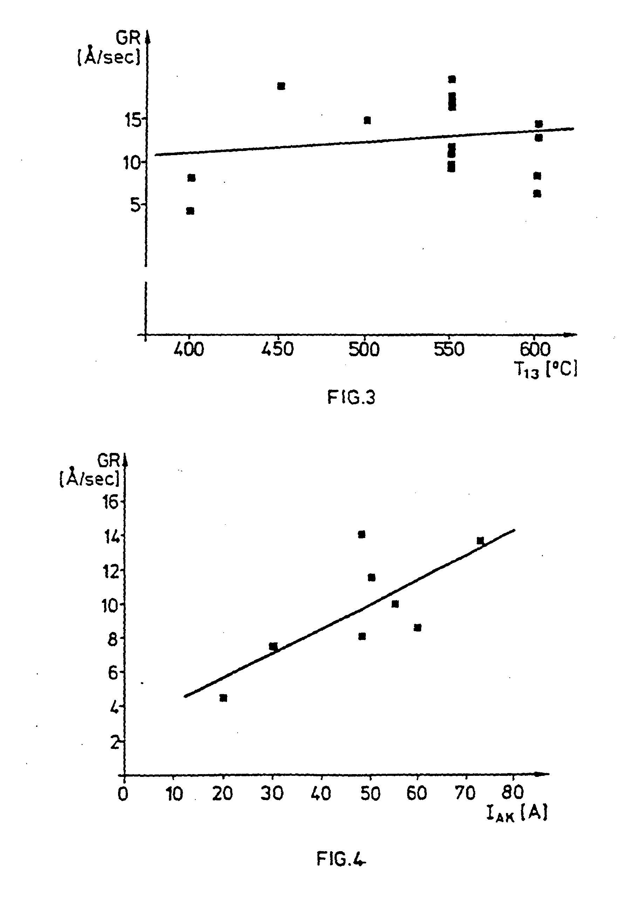

In einem ersten Versuch wurde mit Hilfe der Heizung 17 die Substrattemperatur variiert. Dabei wurden die übrigen Arbeitspunkt-Parameter konstant gelassen. In Fig. 3 ist das Resultat dargestellt. Aus dieser Figur ist ersichtlich, dass die Wachstumsrate GR nur sehr wenig von der Werkstück- bzw. Substrattemperatur $T_{13}$ abhängt. Die grosse Streuung der Messwerte rührt davon her, dass bei der Versuchsanlage vor jeder Abscheidung Betriebsparameter jeweils von Hand wieder eingestellt werden mussten.

Ausgehend von den erwähnten Arbeitspunktwerten wurde nun der Entladestrom $I_{AK}$ variiert, durch Einstellung der Entladespannung $U_{AK}$ und gegebenenfalls Variation des Kathoden-Heizstromes. Alle übrigen Parameter wurden wieder konstant gehalten. Wenn auch der Entladestrom $I_{AK}$ nicht direkt der Ladungsträgerdichte bzw. Plasmadichte an der zu beschichtenden Oberfläche entspricht, so ist doch, bei sonst konstant belassenen Parametern, die Plasmadichte, entsprechend der Stromdichte an der zu beschichtenden Werkstückoberfläche, im wesentlichen proportional zum Entladestrom. Deshalb zeigt das in Fig. 4 dargestellte Resultat durchaus die Proportionalität und den Proportionalitätsfaktor zwischen der Wachstumsrate GR und der Plasmadichte. Diese Proportionalität dürfte anhalten, solange die Gasausnützung nicht ca. 60 % übersteigt und Sättigungseffekte auftreten. Wie erwähnt kann die Plasmadichte nebst z.B. durch Verstellung des Entladestromes auch durch Fokussierung bzw. Defokussierung der Niederspannungsentladung bzw. durch deren Umlenken beeinflusst werden. Auch hier erklärt sich die relative grosse Streuung durch das Vorgehen bei der Einstellung der Entladebedingungen.

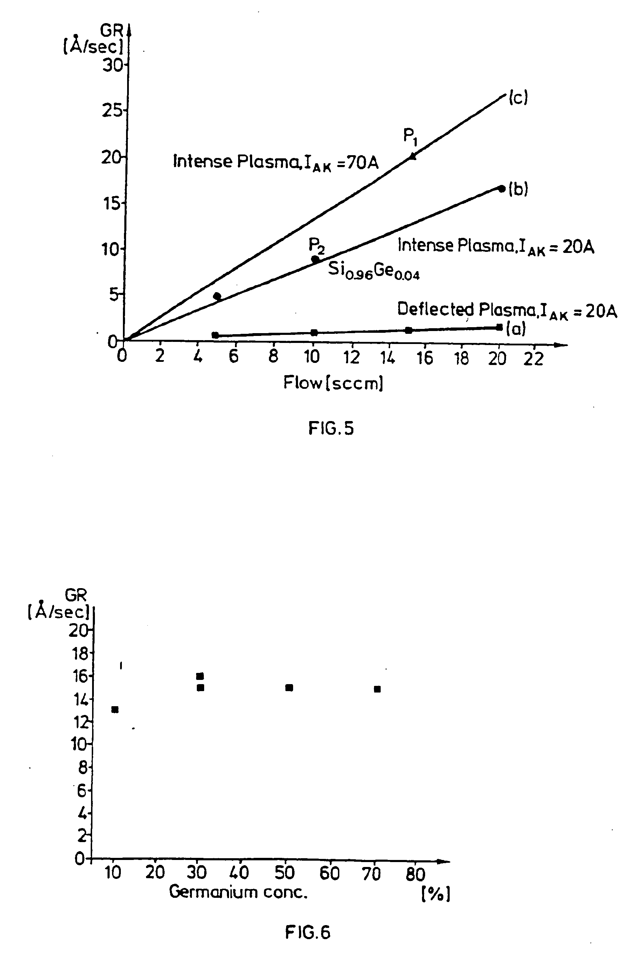

Höchst aufschlussreich ist schliesslich Fig. 5. Diese ist das Ergebnis von Versuchen, bei welchen, bei sonst konstant gehaltenen Parametern, der Reaktivgasfluss F variiert wurde, ausgehend vom Arbeitspunkt 10 sccm. Die Gerade (a) ergab sich bei bezüglich der Achse A von Fig. 1 durch Magnetfeldeinstellung örtlich leicht versetzter Niederspannungsentladung, was am Substrat zu einer Plasmadichtereduktion führte bzw. geringerer Rate, bei einem Entladestrom $I_{AK}$ von 20 A.

Kurve (b) zeigt die Rate bei nicht abgelenkter Entladung und bei $I_{AK}$ = 20 A. Schliesslich zeigt (c) die erhöhte Rate bei nicht abgelenkter Enladung mit $I_{AK}$ = 70 A.

Bei einem Reaktivgasfluss von 10 sccm ergibt sich bei einer Temperatur des Substrates von 550°C und 70 A Entladestrom $I_{AK}$, wie Fig. 3 bestätigt, eine GR von ca. 15 Å/sec.

Bei einem Entladestrom von 70 A bei einem Reaktivgasfluss von 10 sccm wird dieses Resultat auch durch Fig. 4 bestätigt. Die GR fällt bei einem Entladestrom von 20 A auf ca. 6 Å/sec ab.

Es seien nun die erfindungsgemässen Resultate mit den Resultaten vorbekannter Techniken verglichen.

a) Vergleich mit APCVD (2)

Aus Fig. 5 ergibt sich beispielsweise für den Punkt P1:

GR ≈ 1200 Å/min, verglichen mit

GR ≈ 2 x $10^{-2}$ Å/min bei APCVD.

Aus Fig. 5 ergibt sich für den Punkt P1 ein Wert
$GR_F$ von 80 Å/(sccm.min)

Der entsprechende Werte bei APCVD beträgt
GRF ≈ 2 x $10^{-4}$ Å/(sccm.min)

Berechnet man bei LEPECVD gemäss Erfindung die Gasausnützungsziffer für ein 3"-Substrat, so ergibt sich $GA_F$ ≈ 6,8 x $10^{-2}$, entsprechend ca. 6,8 %.

Dabei ist zu berücksichtigen, dass diese Ziffer mit grösser werdenden Substratfläche, z.B. auf 5", noch wesentlich besser wird.

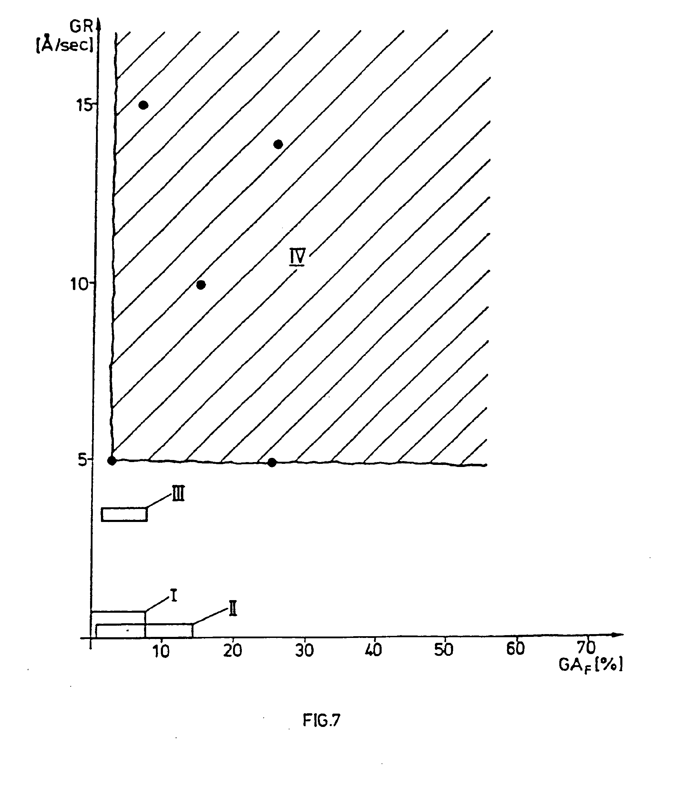

In Fig. 7 sind folgende Resultate dargestellt:

- Im Feld I: für APCVD, LPCVD, RPECVD;

- Im Feld II: für UHVCVD

- Im Feld III: für ECRCVD

- Im Feld IV: gemäss vorliegender Erfindung.

Sie gelten für Temperaturen ≤ 600°C.

In diesem Zusammenhang muss nochmals betont werden, dass es das erfindungsgemässe Vorgehen erlaubt, relativ grosse Flächen zu beschichten, womit die Gasausnützungsziffer $GA_F$ zusätzlich steigt.

Werden, analog, die Grössen Wachstumsrate GR, Wachstumsrate pro Reaktivgasflusseinheit $GR_F$ und die Gasausnützungsziffer $GA_F$ mit den entsprechenden Zahlen für CVD unter atmosphärischen Druckbedingungen verglichen, so ergeben sich erfindungsgemäss in jeder Beziehung drastische Verbesserungen. Vergleicht man schliesslich die Resultate gemäss vorliegender Erfindung mit denjenigen, die erhalten werden, wenn ein PECVD-Verfahren mit Niederspannungsentladung gemäss der DE-OS 36 14 384 betrieben wird, so zeigt sich, dass erstaunlicherweise die erfindungsgemäss erzielte Wachstumsrate von 1200 Å/min wesentlich grösser ist, als die höchsten, mit dem vorbekannten Vorgehen erzielten Wachstumsraten und dass zusätzlich die erfindungsgemäss erzielte Wachstumsrate pro Reaktivgasflusseinheit $GR_F$ praktisch um zwei 10er-Potenzen höherliegt.

Es ist somit höchst erstaunlich, dass durch ganz bestimmte Betriebsbedingungen an der Anlage, prinzipiell wie sie aus der DE-OS 36 14 384 vorbekannt war, derartige Verbesserungen erzielbar sind, unter Berücksichtigung, dass die erfindungsgemäss abgelegten Schichten, bezüglich Defektdichte, Epitaxie-Bedingungen gehorchen.

Dies wurde höchst einfach dadurch überprüft, dass beim beschriebenen Betrieb der Anlage nach Fig. 2 mit den angegebenen Arbeitspunktparametern, bei Einlegen eines monokristallinen Substrates eine hochwertige Epitaxie-Beschichtung erzielt wurde, bei Einlegen eines amorphen Substrates hingegen, bei weiterhin festgehaltenen Arbeitspunktparametern, eine amorphe Beschichtung.

In Fig. 5 ist im weiteren bei P2 der Messpunkt eingetragen, wenn anstelle einer reinen Si-Schicht eine SiGe-Epitaxieschicht abgelegt wird, die 4 % Ge enthält.

Wie bereits daraus ersichtlich, ändern sich entgegen den vorerläuterten Erkenntnissen beim erfindungsgemässen Vorgehen die Verhältnisse nicht, wenn eine Ge/Si-Legierung abgelegt wird. Dies bestätigt Fig. 6, wo in Funktion des Ge-Gehaltes in % bei den angegebenen Arbeitspunkten die Wachstumsrate GR angegeben ist. Daraus ist ersichtlich, dass sich die Wachstumsrate in einem sehr grossen Bereich des Ge- zu Si-Verhältnisses im wesentlichen nicht ändert.

Das erfindungsgemässe Vorgehen wurde primär anhand von Versuchen, Si-, Ge- oder Si/Ge-Legierungsschichten bzw. Ga- und Ga-Verbindungsschichten, alle dotiert und nicht dotiert, abzulegen, erhärtet.

Mit dem erfindungsgemässen Vorgehen werden, kombiniert, höchste Schichtqualität bei sehr hohen Abscheidungsraten und gleichzeitig bei sehr hohem Wirkungsgrad, was abgelegtes Schichtmaterial pro eingelassener Reaktivgasmenge anbelangt, und bei tiefen Temperaturen $\leq 600°C$, erreicht. Damit eignet sich das vorgeschlagene Vorgehen ausserordentlich gut für die industrielle Fertigung, seien dies epitaxialer Schichten oder seien dies anderer Schichten in höchster Qualität.

Literaturangaben:

(1) Handbook of thin-film deposition processes and techniques, ed. Klaus K. Schuegraf, Noyes Publications, New Jersey, U.S.A., 1988, ISBNN 0-8155-1153-1

(2) Atmospheric pressure chemical vapor deposition of Si and SiGe at low temperatures, T.O. Sedgwick and P.D. Agnello, J. Vac.Sci.Technol. A10, 1913 (1992)

(3) Submicron highly doped Si layers grown by LPVPE, L. Vescan, H. Beneking and O. Meyer, J. Cryst. Growth 76, 63 (1986)

(4) Low-temperature silicon epitaxy by ultrahigh vacuum/chemical vapor deposition, B.S. Meyerson, Appl. Phys. Lett. 48, 797 (1986),

(5) Cooperative growth phenomena in silicon/germanium low-temperature epitaxy, B.S. Meyerson, K.J. Uram, and F.K. LeGoues, Appl. Phys. Lett. 53, 2555 (1988),

(6) Silicon epitaxy at 650 - 800°C using low-pressure chemical vapor deposition both with and without plasma enhancement, T.J. Donahue and R. Reif. J. Appl. Phys. 57, 2757 (1985)

(7) Low temperature silicon epitaxy by hot wall ultrahigh vacuum low pressure chemical vapor deposition techniques: Surface optimazion, B.S. Meyerson, E. Ganin, D.A. Smith, and T.N. Nguyen, J. Electrochem. Soc. 133, 1232 (1986)

(8) Kinectics of surface reactions in very low-pressure chemical vapor deposition of Si from $SiH_4$, S.M. Gates and S.K. Kulkarni, Appl. Phys. Lett. 58, 2963 (1991)

(9) Electron cyclotron resonance assisted low temperature ultrahigh vacuum chemical vapor deposition of Si using silane, D.S. Mui, S.F. Fang, and H. Morkoc, Appl. Phys. Lett. 59, 1887 (1991)

(10) Low-temperature silicon homoepitaxy by ultrahigh vacuum electron cyclotron resonance chemical vapor deposition, H-S. Tae, S-H. Hwang, S-J. Park, E. Yoon, and K-W. Whang, Appl. Phys. Lett. 64, 1021 (1994),

(11) Epitaxial growth of Silicon from $SiH_4$ in the temperature range 800° - 1150°C, W.G. Townsend and M.E. Uddin, Solid State Electron 16, 39 (1973)

(12) Homoepitaxial films grown on Si(100) at 150°C by remote plasma-enhanced chemical vapor deposition, L. Breaux, B. Anthony, T. Hsu, B. Banerjee, and A. Tasch. Appl. Phys. Lett. 55, 1885 (1989).

(13) Growth of $Ge_xSi_1$/Si heteroepitaxial films by remote plasma chemical vapour deposition, R. Qian, D. Kinosky, T. Hsu, J. Irby, A. Mahajan, S. Thomas, B. Anthony, S. Banerjee, A. Tasch, L. Rabenberg and C. Magee, J. Vac.

Sci. Technol. A 10, 1920 (1992)

(14) Low temperature epitaxial silicon film growth using high vacuum electron-cyclotron-resonance plasma deposition, S.J. DeBoer, V.L. Dalal, G. Chumanov, and R. Bartels, Appl. Phys. Lett. 66, 2528 (1995).

(15) Hydrogen plasma chemical cleaning of metallic substrates and Silicon wafers; W. Korner et al., Balzers Ltd., Liechtenstein, Surface and coatings technology, 76 - 77 (1995) 731 - 737.

**Patentansprüche**

1. Verfahren zur Herstellung von mit dünnen Halbleiterfilmen beschichteten Substraten, mittels PECVD, bei einem Totaldruck $P_T$ von

$$10^{-4}mbar \leq P_T \leq 10^{-1}mbar,$$

einem Reaktivgas-Partialdruck $P_R$ von

$$10^{-5}mbar \leq P_R \leq 10^{-1}mbar,$$

und unter Einsatz einer DC-Niederspannungsentladung mit einer Entladespannung $U_{AK}$ von:

$$10V \leq U_{AK} \leq 80V$$

einem Entladestrom $I_{AK}$ von:

$$5A \leq I_{AK} \leq 400A$$

sowie einer gemessenen minimalen Stromdichte von mindestens 0,05A/cm$^2$ am Ort des abzulegenden Films, derart, dass eine Wachstumsrate GR von mindestens 30nm/min eingehalten wird, und am Ort der abzulegenden Schicht, durch Einstellung einer Werkstückspannung $U_s$ von:

$$-25 \leq U_s \leq +25V$$

die Jonenenergie höchstens 15eV ist und an einem Querschnittspräparat des beschichteten Substrates mittels Transmissionenelektronen-Mikroskopie, mit einer Vergrösserung von 220'000, jeweils in einem durchstrahlten Bereich von 10-15$\mu$m entlang der Grenzfläche zum Substrat, keine Defekte sichtbar sind.

2. Verfahren nach Anspruch 1, **dadurch gekennzeichnet, dass** die Beschichtung mit einer Gasausnützungs-Ziffer

$$1 \% \leq GA_F \leq 90 \%$$

erfolgt, vorzugsweise mit

$$GA_F \geq 5 \ \%$$

3. Verfahren nach Anspruch 1, **dadurch gekennzeichnet, dass** die Wachstumsrate beträgt:

$$GR \geq 60 \ nm/min,$$

besonders bevorzugt

$$GR \geq 100 \ nm/min \ beträgt.$$

4. Verfahren nach einem der Ansprüche 1 bis 3, **dadurch gekennzeichnet, dass** man die minimale Stromdichte zu mindestens 0,1 A/cm$^2$ bis hin zu einer Dichte von höchstens Entladestrom/Substratflächewählt.

5. Verfahren nach Anspruch 4, **dadurch gekennzeichnet, dass** die gemessene Stromdichte überwiegend durch Elektronen-Einfall erzeugt wird.

6. Verfahren nach einem der Ansprüche 1 bis 5, **dadurch gekennzeichnet, dass** man den Entladestrom $I_{AK}$ zu

$$20 \ A \leq I_{AK} \leq 100 \ A$$

wählt.

7. Verfahren nach einem der Ansprüche 1 bis 6, **dadurch gekennzeichnet, dass** man die Entladungsspannung $U_{AK}$ zu

$$20 \ V \leq U_{AK} \leq 35 \ V$$

wählt.

8. Verfahren nach einem der Ansprüche 1 bis 7, **dadurch gekennzeichnet, dass** man den Reaktivgas-Partialdruck $P_R$ zu

$$10^{-4} \ mbar \leq P_R \leq 10^{-2} \ mbar$$

wählt.

9. Verfahren nach einem der Ansprüche 1 bis 8, **dadurch gekennzeichnet, dass** man eine Heisskathoden-Niederspannungs-Entladung, einsetzt.

10. Verfahren nach einem der Ansprüche 1 bis 9, **dadurch gekennzeichnet, dass** man den Totaldruck $P_T$ wie folgt einstellt:

$$10^{-3} \ mbar \leq P_T \leq 10^{-2} \ mbar.$$

**11.** Verfahren nach einem der Ansprüche 1 bis 10, **dadurch gekennzeichnet, dass** man im Rezipienten einen Arbeitsgaspartialdruck $P_A$ wie folgt einstellt:

$$10^{-4} \text{ mbar} \leq P_A \leq 10^{-1} \text{ mbar},$$

vorzugsweise

$$10^{-3} \text{ mbar} \leq P_A \leq 10^{-2} \text{ mbar}.$$

**12.** Verfahren nach einem der Ansprüche 1 bis 11, **dadurch gekennzeichnet, dass** man die Werkstück-Spannung $U_S$ bezüglich Entladungsanode negativ wählt, vorzugsweise zwischen -15V und -3V.

**13.** Verfahren nach einem der Ansprüche 1 bis 12, **dadurch gekennzeichnet, dass** man entlang der Entladungs-Strecke eine Hilfsanode vorsieht, vorzugsweise in Form einer die Entladung umschliessende Ringanode, und diese auf eine vorzugsweise einstellbare Spannung bezüglich Entladungskathode betreibt, die vorzugsweise nicht grösser ist als die Entladungs-Spannung.

**14.** Verfahren nach einem der Ansprüche 1 bis 13, **dadurch gekennzeichnet, dass** man das Werkstück bezüglich Anode der Entladung auf der Spannung $U_S$ zum Ablegen von Filmen aus Si-, Ge- oder deren Verbindungen betreibt, die

$$-20 \text{ V} \leq U_S \leq +20V$$

ist, dabei vorzugsweise auf einer negativen Spannung.

**15.** Verfahren nach einem der Ansprüche 1 bis 14, **dadurch gekennzeichnet, dass** man die Werkstücktemperatur auf höchstens 600°C hält, vorzugsweise zwischen 300°C und 600°C, vorzugsweise für Si-, Ge- oder deren Verbindungen und vorzugsweise für Ga-Verbindungen zwischen 300°C und 800°C.

**16.** Verfahren nach einem der Ansprüche 1 bis 15, **dadurch gekennzeichnet, dass** man die Beschichtung mit einer Beschichtungsrate pro Reaktivgasfluss-Einheit $GR_F$ vornimmt, welche mindestens 7,5 Å/(sccm.min) beträgt, vorzugsweise mindestens 40 Å/(sccm.min), besonders vorzugsweise mindestens 75 Å/(sccm.min) beträgt.

**17.** Verfahren nach einem der Ansprüche 1 bis 16, **dadurch gekennzeichnet, dass** man erwünschte Beschichtungsratenänderungen durch im Wesentlichen hierzu proportionales Verstellen des Reaktivgasflusses in den Vakuumrezipienten vornimmt.

**18.** Verfahren nach einem der Ansprüche 1 bis 17, **dadurch gekennzeichnet, dass** man erwünschte Beschichtungsratenänderungen durch im Wesentlichen hierzu proportionales Verstellen der Entladungs-Stromdichte vornimmt, vorzugsweise durch Verstellung des Entladestromes und/oder der Entladespannung und/oder durch Umlenkung und/oder durch Bündelungsvariation der Entladung bezüglich des Werkstückes, letztere vorzugsweise elektrostatisch und/oder magnetisch.

**19.** Verfahren nach einem der Ansprüche 1 bis 18, **dadurch gekennzeichnet, dass** man das Werkstück unabhängig von der Entladung heizt.

**20.** Verwendung des Verfahrens nach einem der Ansprüche 1 bis 19 zur Herstellung von Epitaxie-Schichten.

**21.** Verwendung des Verfahrens nach einem der Ansprüche 1 bis 19 für die Herstellung von Substraten mit einer Halbleiter-Epitaxieschicht oder einer polykristallinen oder einer amorphen Halbleiterschicht, vorzugsweise gesteuert durch das unbeschichtete Substrat, insbesondere dessen Oberflächeneigenschaften.

22. Verwendung nach einem der Ansprüche 20 oder 21 für die Herstellung von Substraten mit einer Silizium- und/oder Germaniumschicht oder einer Si/Ge-Legierungsschicht, vorzugsweise dotiert mit mindestens einem Element aus den Gruppen III und/oder V des Periodensystems.

23. Verwendung nach einem der Ansprüche 20 bis 22 für die Herstellung von Substraten mit einer Ga-Schicht oder einer Ga-Verbindungs-Schicht, vorzugsweise dotiert mit mindestens einem Element der Gruppen II, III, IV oder VI des Periodensystems, z.B. Mg oder Si.

24. Verwendung nach einem der Ansprüche 20 bis 23, **dadurch gekennzeichnet, dass** man als Reaktivgas mindestens ein Si- und/oder Ge-haltiges Gas einsetzt und vorzugsweise zusätzlich Wasserstoffgas in den Reaktionsraum einbringt.

25. Verwendung nach einem der Ansprüche 20 bis 24 für die Werkstückbeschichtung mit Beschichtungsraten pro Reaktivgasfluss-Einheit, $GR_F$, von mindestens 7,5 Å/(sccm.min), vorzugsweise von mindestens 40 Å/(sccm.min), vorzugsweise gar von mindestens 75 Å/(sccm.min).

## Claims

1. Method for the production of substrates coated with thin semiconductor film by means of PECVD at a total pressure $P_T$ of

$$10^{-4}\,\text{mbar} \leq P_T \leq 10^{-1}\,\text{mbar}$$

a reactive gas partial pressure $P_R$ of

$$10^{-5}\,\text{mbar} \leq P_R \leq 10^{-1}\,\text{mbar}$$

and using a DC low voltage discharge with a discharge voltage $U_{AK}$ of:

$$10\,\text{V} \leq U_{AK} \leq 80\,\text{V}$$

a discharge current $I_{AK}$ of:

$$5\,\text{A} \leq I_{AK} \leq 400\,\text{A}$$

and a measured minimum current density of at least 0.05 A/cm$^2$ at the site of the film to be deposited such that a growth rate GR of at least 30 nm/min is achieved, and at the site of the layer to be deposited, by setting a workpiece voltage $U_S$ of:

$$-25 \leq U_S \leq +25\,\text{V}$$

the ion energy is maximum 15 eV and at a cross-section preparation of the coated substrate, by means of transmission electron microscopy with a magnification of 220,000, in an irradiated range of 10 - 15 $\mu$m along the limit surface to the substrate, no defects are visible.

2. Method according to claim 1, **characterised in that** the coating takes place with a gas utilisation count of

$$1\% \leq GA_F \leq 90\%$$

preferably with

$$GA_F \geq 5\%.$$

3.  Method according to claim 1, **characterised in that** the growth rate is:

$$GR \geq 60 \text{ nm/min},$$

particularly preferably

$$GR \geq 100 \text{ nm/min}.$$

4.  Method according to any of claims 1 to 3, **characterised in that** the minimum current density is selected as at least 0.1 A/cm$^2$ up to a density of maximum discharge current/substrate area.

5.  Method according to claim 4, **characterised in that** the current density measured is generated predominantly by electron incidence.

6.  Method according to any of claims 1 to 5, **characterised in that** the discharge current $I_{AK}$ is selected as

$$20 \text{ A} \leq I_{AK} \leq 100 \text{ A}.$$

7.  Method according to any of claims 1 to 6, **characterised in that** the discharge voltage $U_{AK}$ is selected as

$$20 \text{ V} \leq U_{AK} \leq 35 \text{ V}.$$

8.  Method according to any of claims 1 to 7, **characterised in that** the reactive gas partial pressure $P_R$ is selected as

$$10^{-4} \text{ mbar} \leq P_R \leq 10^{-2} \text{ mbar}.$$

9.  Method according to any of claims 1 to 8, **characterised in that** a hot cathode low voltage discharge is used.

10. Method according to any of claims 1 to 9, **characterised in that** the total pressure $P_T$ is selected as

$$10^{-3} \text{ mbar} \leq P_T \leq 10^{-2} \text{ mbar}.$$

11. Method according to any of claims 1 to 10, **characterised in that** in the recipient a working gas partial pressure $P_A$ is set as follows:

$$10^{-4}\,\text{mbar} \leq P_A \leq 10^{-1}\,\text{mbar},$$

preferably

$$10^{-3}\,\text{mbar} \leq P_A \leq 10^{-2}\,\text{mbar}.$$

**12.** Method according to any of claims 1 to 11, **characterised in that** the workpiece voltage $U_S$ is selected negative in relation to the discharge anode, preferably between -15V and -3V.

**13.** Method according to any of claims 1 to 12, **characterised in that** along the discharge path an auxiliary anode is provided preferably in the form of a ring anode surrounding the discharge, and this is operated at a voltage, preferably adjustable in relation to the discharge cathode, that is preferably no greater than the discharge voltage.

**14.** Method according to any of claims 1 to 13, **characterised in that** the workpiece is operated in relation to the discharge anode at the voltage $U_S$ for depositing films of Si, Ge or their compounds, that is

$$-20\,\text{V} \leq U_S \leq +20\text{V}$$

preferably at a negative voltage.

**15.** Method according to any of claims 1 to 14, **characterised in that** the workpiece temperature is held at maximum 600°C, preferably between 300°C and 600°C, preferably for Si, Ge or their compounds and preferably for Ga compounds between 300°C and 800°C.

**16.** Method according to any of claims 1 to 15, **characterised in that** the reactive coating takes place with a coating rate per reactive gas flow unit $GR_F$ which is at least 7.5 Å/(sccm.min), preferably at least 40 Å/(sccm.min), particularly preferably at least 75 Å/(sccm.min).

**17.** Method according to any of claims 1 to 16, **characterised in that** desired coating rate changes are made by substantially proportional adjustment of the reactive gas flow in the vacuum recipient.

**18.** Method according to any of claims 1 to 17, **characterised in that** desired coating rate changes are made by substantially proportional adjustment of the discharge current density, preferably by adjustment of the discharge current and/or discharge voltage and/or by deflection and/or by bundling variation of the discharge in relation to the workpiece, the latter preferably electrostatically and/or magnetically.

**19.** Method according to any of claims 1 to 18, **characterised in that** the workpiece is heated independently of the discharge.

**20.** Use of the method according to any of claims 1 to 19 for the production of epitaxial layers.

**21.** Use of the method according to any of claims 1 to 19 for the production of substrates with a semiconductor epitaxial layer or a polycrystalline or amorphous semiconductor layer, preferably controlled by the uncoated substrate, in particular its surface properties.

**22.** Use according to any of claims 20 or 21 for the production of substrates with a silicon and/or germanium layer or an Si/Ge alloy layer, preferably doped with at least one element from groups III and/or V of the periodic system.

**23.** Use according to any of claims 20 or 22 for the production of substrates with a Ga layer or a Ga compound layer, preferably doped with at least one element of groups II, III, IV or VI of the period system, e.g. Mg or Si.

**24.** Use according to any of claims 20 to 23, **characterised in that** as a reactive gas at least one Si- and/or Ge-containing gas is used, and preferably also hydrogen gas is introduced into the reaction chamber.

**25.** Use according to any of claims 20 to 24 for workpiece coating with coating rates per reactive gas flow unit $GR_F$ of at least 7.5 Å/(sccm.min), preferably at least 40 Å/(sccm.min), particularly preferably at least 75 Å/(sccm.min).

**Revendications**

**1.** Procédé pour fabriquer des substrats revêtus de minces films semi-conducteurs, par PECVD (dépôt chimique en phase vapeur avec utilisation d'un plasma) avec une pression totale $P\tau$

$$10^{-4}\text{mbar} \leq P\tau \leq 10^{-1}\text{mbar},$$

et une pression partielle de gaz réactif $P_R$

$$10^{-5}\text{mbar} \leq P_R \leq 10^{-1}\text{mbar},$$

et à l'aide d'une décharge de courant continu basse tension avec une tension de décharge $U_{AK}$

$$10V \leq U_{AK} \leq 80V,$$

un courant de décharge $I_{AK}$:

$$5A \leq I_{AK} \leq 400A$$

et une densité de courant minimale mesurée d'au moins 0,05 A/cm$^2$ à l'endroit du film à déposer, de sorte qu'un taux de croissance GR d'au moins 30 nm/min est respecté et qu'à l'endroit de la couche à déposer, grâce au réglage d'une tension de pièce à traiter $U_S$ :

$$-25 \leq U_S \leq +25V,$$

l'énergie ionique est au maximum de 15eV, et sur une coupe du substrat revêtu, à l'aide d'une microscopie électronique à transmission avec un agrandissement de 220'000, dans une zone examinée de 10-15 μm le long de la surface limite avec le substrat, aucun défaut n'est visible.

**2.** Procédé selon la revendication 1, **caractérisé en ce que** l'application du revêtement se fait avec un indice d'utilisation du gaz

$$1\% \leq GA_F \leq 90\%,$$

de préférence

$$GA_F \geq 5\%.$$

**3.** Procédé selon la revendication 1, **caractérisé en ce que** le taux de croissance est

$$GR \geq 60 \text{ nm/min},$$

de préférence

$$GR \geq 100 \text{ nm/min.}$$

**4.** Procédé selon l'une des revendications 1 à 3, **caractérisé en ce qu'**on choisit une densité de courant minimale d'au moins 0,1 A/cm$^2$ jusqu'à une densité égale au maximum au courant de décharge/surface de substrat.

**5.** Procédé selon la revendication 4, **caractérisé en ce que** la densité de courant mesurée est générée principalement par l'arrivée des électrons.

**6.** Procédé selon l'une des revendications 1 à 5, **caractérisé en ce qu'**on choisit pour le courant de décharge

$$20 \text{ A} \leq I_{AK} \leq 100 \text{ A.}$$

**7.** Procédé selon l'une des revendications 1 à 6, **caractérisé en ce qu'**on choisit pour la tension de décharge $U_{AK}$

$$20 \text{ V} \leq U_{AK} \leq 35 \text{ V.}$$

**8.** Procédé selon l'une des revendications 1 à 7, **caractérisé en ce qu'**on choisit pour la pression partielle de gaz réactif $P_R$

$$10^{-4} \text{ mbar} \leq P_R \leq 10^{-2} \text{mbar.}$$

**9.** Procédé selon l'une des revendications 1 à 8, **caractérisé en ce qu'**on utilise une décharge basse tension de cathode chaude.

**10.** Procédé selon l'une des revendications 1 à 9, **caractérisé en ce qu'**on règle la pression totale $P\tau$ comme suit:

$$10^{-3} \text{mbar} \leq P\tau \leq 10^{-2} \text{mbar.}$$

**11.** Procédé selon l'une des revendications 1 à 10, **caractérisé en ce qu'**on règle dans le récipient une pression partielle de gaz de travail $P_A$ comme suit :

$$10^{-4} \text{mbar} \leq P_A \leq 10^{-1} \text{mbar,}$$

de préférence

$$10^{-3} \text{mbar} \leq P_A \leq 10^{-2} \text{mbar.}$$

**12.** Procédé selon l'une des revendications 1 à 11, **caractérisé en ce qu'**on choisit une tension de pièce $U_S$ négative par rapport à l'anode de décharge, de préférence entre -15V et -3V.

**13.** Procédé selon l'une des revendications 1 à 12, **caractérisé en ce qu'**on prévoit le long de la voie de décharge une anode auxiliaire, de préférence sous la forme d'une anode annulaire entourant la décharge, et on fait fonctionner cette anode à une tension de préférence réglable, par rapport à la cathode de décharge, qui n'est pas supérieure, de préférence, à la tension de décharge.

**14.** Procédé selon l'une des revendications 1 à 13, **caractérisé en ce que** pour déposer des films de Si, de Ge ou de leurs composés, on fait fonctionner la pièce à traiter, par rapport à l'anode de la décharge, à la tension $U_S$

$$-20V \leq U_S \leq +20V,$$

de préférence à une tension négative.

15. Procédé selon l'une des revendications 1 à 14, **caractérisé en ce qu'**on maintient la température de la pièce à traiter à 600°C maximum, de préférence entre 300°C et 600°C, de préférence pour Si, Ge ou leurs composés et de préférence pour des composés de Ga entre 300°C et 800°C.

16. Procédé selon l'une des revendications 1 à 15, **caractérisé en ce qu'**on dépose le revêtement à une vitesse de revêtement par unité de flux de gaz réactif $GR_F$ qui est d'au moins 7,5 Å/(sccm/min), de préférence d'au moins 40 Å/(sccm/min), et plus spécialement d'au moins 75 Å/(sccm/min).

17. Procédé selon l'une des revendications 1 à 16, **caractérisé en ce qu'**on procède aux modifications de vitesse de revêtement voulues en réglant le flux de gaz réactif, globalement proportionnellement à ces modifications, dans les récipients à vide.

18. Procédé selon l'une des revendications 1 à 17, **caractérisé en ce qu'**on procède aux modifications de vitesse de revêtement voulues grâce au réglage de la densité de courant de décharge, globalement proportionnellement à ces modifications, de préférence grâce au réglage du courant de décharge et/ou de la tension de décharge et/ou à la déviation et/ou à la modification de collimation de la décharge par rapport à la pièce à traiter, pour cette dernière de préférence par voie électrostatique et/ou magnétique.

19. Procédé selon l'une des revendications 1 à 18, **caractérisé en ce qu'**on chauffe la pièce à traiter indépendamment de la décharge.

20. Utilisation du procédé selon l'une des revendications 1 à 19 pour fabriquer des couches épitaxiales.

21. Utilisation du procédé selon l'une des revendications 1 à 19 pour fabriquer des substrats avec une couche épitaxiale semi-conductrice ou une couche semi-conductrice polycristalline ou amorphe, de préférence de manière commandée par le substrat non revêtu, en particulier par ses caractéristiques de surface.

22. Utilisation selon l'une des revendications 20 ou 21 pour fabriquer des substrats avec une couche de silicium et/ou de germanium ou avec une couche d'alliage Si/Ge, de préférence dopés avec au moins un élément des groupes III et/ou V du système périodique.

23. Utilisation selon l'une des revendications 20 à 22 pour fabriquer des substrats avec une couche de Ga ou avec une couche de composé de Ga, de préférence dopés avec au moins un élément des groupes II, III, IV ou VI du système périodique, par exemple Mg ou Si.

24. Utilisation selon l'une des revendications 20 à 23, **caractérisée en ce qu'**on utilise comme gaz réactif au moins un gaz contenant du Si et/ou du Ge et on introduit de préférence dans l'espace de réaction, en supplément, du gaz hydrogène.

25. Utilisation selon l'une des revendications 20 à 24 pour revêtir des pièces à une vitesse de revêtement par unité de flux de gaz réactif, $GR_F$, d'au moins 7,5 Å/(sccm/min), de préférence d'au moins 40 Å/(sccm/min), voire de préférence d'au moins 75 Å/(sccm/min).

FIG.1

FIG.2

FIG.3

FIG.4

FIG.5

FIG.6

FIG.7